# EUROPÄISCHE PATENTANMELDUNG

(11) **EP 0 778 089 A1**
(43) Veröffentlichungstag der Anmeldung: **11.06.1997**
(21) Anmeldenummer: 97100404.9
(22) Anmeldetag: 31.05.1994
(51) Int. Cl.: B05D 7/24, C08J 7/00, C23C 16/04

(54) **Einrichtung zum Herstellen einer polymeren Beschichtung an Kunststoff-Hohlkörpern**

(30) Priorität: 01.06.1993 DE 4318084; 01.06.1993 DE 4318086
(62) Teilanmeldung aus: 94916150.9
(71) Anmelder: KAUTEX WERKE REINOLD HAGEN AG, D-53229 Bonn (DE); Buck Werke GmbH & Co, 73337 Bad Überkingen (DE)
(72) Erfinder: Esser, Klaus, Dr., 53639 Königswinter (DE); Karsch, Ulrich, 53859 Niederkassel (DE); Runkel, Jürgen, 53229 Bonn (DE); Grünwald, Heinrich, 72810 Gomaringen (DE); Nauenburg, Klaus, 72072 Tübingen (DE); Weichert, Jürgen, 70794 Filderstadt (DE); Diener, Christoph, 72202 Nagold (DE)
(74) Vertreter: Koepsell, Helmut, Dipl.-Ing.

(57) **Zusammenfassung**

Die Erfindung betrifft die Einrichtung zum Herstellen einer polymeren Beschichtung auf der inneren Oberfläche eines Kunststoffhohlkörpers durch Niederdruck-Plasmapolymerisation mit einer den Hohlkörper aufnehmenden Vakuumkammer und Mitteln zum Einführen der Ausgangssubstanz(en) für die Bildung der polymeren Deckschicht und Mitteln zum Einkoppeln von hochfrequenter elektromagnetischer Energie zur Erzeugung des Plasmas. Ferner ist die innere Begrenzung der Vakuumkammer der äußeren Gestalt des Hohlkörpers angepaßt.

## Beschreibung

Die Erfindung betrifft eine Einrichtung zum Herstellen einer polymeren Beschichtung auf wenigstens einem Teilbereich der inneren Oberfläche eines wenigstens teilweise aus Kunststoff bestehenden Hohlkörpers unter Anwendung der Niederdruck-Plasmapolymerisation.

Bei einem durch die DE-PS 3,632,748 bekannten derartigen Verfahren zur Bildung diffusionshemmender Schichten mittels Plasmapolymerisation von nicht näher bezeichneten Monomeren erfolgt die Plasmaanregung durch von außen eingekoppelte Mikrowellen. Ein auf diese Weise angeregtes Plasma wird für Hohlkörper kleineren Volumens geeignet sein. Bei Hohlkörpern größeren Volumens ist jedoch ein mittels Mikrowellen angeregtes Plasma nur bei Anwendung zusätzlicher Maßnahmen so gleichmäßig, wie es zur Erzeugung einer Deckschicht erforderlich ist, die auch bei größerer Flächenausdehnung, wie sie bei einem Hohlkörper größeren Volumens, beispielsweise einem Kfz.-Tank gegeben ist, die erforderliche Gleichmäßigkeit aufweist.

An anderer Stelle wird berichtet, daß eine polymere Deckschicht, die durch Mikrowellen-Plasmapolymerisation von Äthylen bzw. Äthylen/Argonmischungen auf einem Kraftstoffbehälter aufgebracht wurde, die Permeation von methanolfreiem Prüfkraftstoff durch Hochdruck-Polyäthylen (HDPE) auf ca. 2% des ursprünglichen Wertes vermindert. Dabei wird der Schluß gezogen, daß sich eine Verbesserung speziell mit einer Plasmaanregung durch Mikrowellen, nicht aber durch Wechselfrequenz im MHz-Bereich erzielen läßt (R. Ludwig, "Plasmapolymerisation - Ein Verfahren zur Erzeugung dünner Schichten", Dissertation an der RWTH Aachen, 1989).

In DE-OS 3,908,418 wird die Plasmapolymerisation von polaren Barriereschichten unter Anwendung eines Plasmas beschrieben, das durch Wechselspannungen im MHz-Bereich angeregt wird. Nachteilig ist, daß polare Barriereschichten eine abstoßende Wirkung auf unpolare Bestandteile von Kraftstoffen, nicht jedoch in Bezug auf Methanol ausüben, so daß die erzielbare Barrierewirkung bei methanolhaltigen Kraftstoffen nicht ausreicht.

Der Erfindung liegt die Aufgabe zugrunde, ein Verfahren verfügbar zu machen, welches die wirtschaftliche Herstellung wenigstens einer großflächigen polymeren Deckschicht auf einem Kunststoffsubstrat, insbesondere einem Kunststoffhohlkörper, ermöglicht, wobei die Deckschicht trotz ihrer großflächigen Ausdehnung möglichst einheitliche Eigenschaften aufweisen und somit eine ausreichende Barrierewirkung erzielen soll. Dies soll auch bei einem methanolhaltigen Füllgut, beispielsweise methanolhaltigem Kraftstoff, der Fall sein. Die Deckschicht soll eine Barrierewirkung gewährleisten, die den heutigen und ggf. in Zukunft zu erwartenden Anforderungen an die Undurchlässigkeit derartiger Hohlkörper für das Füllgut genügt. Ferner wird aus wirtschaftlichen Gründen angestrebt, die wenigstens eine Deckschicht in möglichst kurzer Zeilt herzustellen.

Als schichtbildende Komponenten können dabei Verbindungen eingesetzt werden, die unter Plasmabedingungen relativ schnell eine polymere Deckschicht bilden. Dazu gehören beispielsweise Olefine, z. B. Ethylen, gespannte Zykloalkane, z. B. Zyklopropan, Aromaten, Heteroaromaten, z. B. Pyrrol oder Thiophen. Im allgemeinen gilt dabei jedoch, daß mit zunehmender Geschwindigkeit der Schichtbildung der Vernetzungsgrad abnimmt, also überwiegend Ketten gebildet werden.

Da mit abnehmendem Vernetzungsgrad im allgemeinen auch die Sperrwirkung abnimmt, kann es gemäß einem Vorschlag der Erfindung zweckmäßig sein, neben dem Reaktionsgas, welches die überwiegend kettenbildende Komponente enthält, eine zusätzliche Komponente darstellende Moleküle in der das Plasma bildenden Gasatmosphäre vorzusehen, die unter Plasmabedingungen innerhalb der sich bildenden polymeren Deckschicht überwiegend Verzweigungsstellen in den Polymerketten, insbesondere Vernetzungsstellen zwischen Polymerketten, erzeugen. Dafür haben sich hoch ungesättigte Kohlenwasserstoffverbindungen, z. B. Acetylene oder Allene oder Verbindungen, die unter Plasmabedingungen solche hochgesättigten Kohlenstoff-Verbindungen bilden, z. B. Cyclobuten, als besonders geeignet erwiesen.

Die Verzweigungs- bzw. Vernetzungsstellen ausbildende Komponente kann zusätzlich zu der überwiegend kettenbildenden Komponente in die das Plasma bildende Gasatmosphäre eingeführt werden. Es besteht aber auch die Möglichkeit, daß beide schichtbildenden Komponenten als Strukturelemente desselben Moleküls in das Plasma eingeführt werden, wobei die Moleküle dieser Ausgangssubstanz unter den Bedingungen des Plasmas in Strukturen gespalten werden, die die beiden genannten Komponenten bilden.

Dabei ist die Relation zwischen den beiden Komponenten, also der überwiegend kettenbildenden Komponente und der überwiegend Verzweigungs- bzw. Vernetzungstellen ausbildenden Komponente, so zu wählen, daß die sich aus diesen Komponenten bildende Deckschicht noch keine merkliche Versprödung erfährt, die dazu führen könnte, daß die Deckschicht bezüglich ihrer elastischen Verformbarkeit wesentlich andere Eigenschaften aufweist als die sie tragende eigentliche Wandung des Hohlkörpers, die, da sie aus thermoplastischem Kunststoff besteht, unter der Einwirkung von mechanischen Beanspruchungen relativ leicht elastisch verformbar ist. Bei einer aufgrund der Vernetzung stark versprödeten Deckschicht würde die Gefahr bestehen, daß diese unter der Einwirkung von mechanischen Beanspruchungen und durch diese verursachte Verformungen des Hohlkörpers sich von der Wandung desselben löst und/oder Risse bildet. Das optimale Ausmaß der Vernetzung, bei dem einerseits in kurzer Zeit eine Deckschicht mit der gewünschten Undurchlässigkeit entsteht, andererseits jedoch die Versprödung noch nicht zu einer merklichen Veränderung der mechanischen Eigenschaften dieser Deckschicht führt, kann durch einfache Versuche festgestellt werden.

Die Geschwindigkeit der Bildung der Deckschicht hängt im allgemeinen auch ab von der Menge der pro Zeiteinheit dem Plasma zugeführten polymerisierbaren Substanzen, wobei mit zunehmender Menge pro Zeiteinheit auch die Geschwindigkeit, mit welcher die Deckschicht gebildet wird, zunimmt. Allerdings werden hierbei im allgemeinen gewisse Grenzen einzuhalten sein, da es sonst zur Bildung eines staubigen Niederschlages auf der Substratoberfläche bzw. der sich bildenden Deckschicht kommen kann. Die Bildung von derartigen Staubpartikeln ist insbesondere darauf zurückzuführen, daß Teile der schichtbildenden Komponenten bereits vor Erreichen der Oberfläche des Substrates bzw. der sich bildenden Deckschicht "kondensieren", also von der gas- oder dampfförmigen Phase in die flüssige und schließlich in die feste Phase übergehen. Der Nachteil der Bildung derartiger Staubpartikel besteht darin, daß sie sich auf der Oberfläche des Substrates bzw. der sich bildenden Deckschicht absetzen mit der Folge, daß sich an diesen Stellen keine porenfreie Deckschicht bildet und nach späteren Ablösen der Staubpartikel von der Oberfläche an diesen Stellen die Beschichtigung nicht die notwendige Undurchlässigkeit aufweist. Außerdem ist die Bildung von Staub innerhalb von Behältern, insbesondere von Kraftstoffbehältern, generell unerwünscht.

Es kann somit bei Vorliegen bestimmter Betriebsbedingungen zweckmäßig sein, der in das Plasma einzuführenden Ausgangssubstanz noch eine der Bildung von Staub entgegenwirkende Komponente hinzuzufügen. Dabei kann es sich um inerte Gase oder Dämpfe handeln, die das Reaktionsgas verdünnen, so daß die Polymerisation in der Gasphase verlangsamt wird. Dies wird allerdings nur dann zweckmäßig sein, wenn dadurch die Geschwindigkeit, mit welcher die Deckschicht gebildet wird, die Wirtschaftlichkeit des Verfahrens nicht beeinträchtigt. Eine Vermeidung oder zumindest Verringerung der Staubbildung kann aber auch dadurch erreicht werden, daß als Staubverhinderer solche Substanzen hinzugefügt werden, die im Plasma reaktive Teilchen, z. B. Monoradikale bilden, die die Entstehung großer Aggregate in der Gasphase hemmen. Derartige die Staubbildung hemmende Substanzen wirken im wesentlichen in der Weise, daß einige der Valenzen der schichtbildenden Komponenten gesättigt werden, wodurch die Teilchen der letzteren weniger reaktiv sind. Dadurch wird erreicht, daß die Polymerisation zumindest überwiegend erst auf der Oberfläche des Substrats bzw. der in der Bildung befindlichen Deckschicht erfolgt, so daß eine bereits in der Gasphase stattfindende Polymerisation, die letzten Endes, abgesehen von der möglichen Porenbildung, die Effizienz der Schichtbildung herabsetzt, weitestgehend vermieden wird.

Als inerter Staubverhinderer, die die Konzentration der polymerisierenden Teilchen verringern, können Argon oder Helium eingesetzt werden. Als Bildner von reaktiven Teilchen, deren Reaktion mit den schichtbildenden Komponenten hingegen die Geschwindigkeit der Bildung der Abdeckschicht kaum verringert, kommen H₂, CH₄, N₂, NH₃, Ethan und andere niedere Alkane in Frage.

Als hochfrequente elektromagnetische Energie zur Erzeugung des Plasmas kann eine Radiofrequenz verwendet werden. Diese hat einmal den Vorteil, daß die zur Erzeugung des Plasmas erforderliche Energie merklich geringer ist als im Falle der Plasmaerzeugung durch Mikrowellen. Dadurch ist das durch Radiofrequenz erzeugte Plasma weniger "scharf", welche Tatsache - unabhängig von der Menge der zugeführten schichtbildenden Komponenten - zu einem langsameren Reaktionsablauf führt mit der Folge, daß die durch Plasmapolymerisation aufgebrachte Deckschicht - bei sonst gleichen Bedingungen - eine bessere Qualität als bei Verwendung von Mikrowellen aufweist. Ein weiterer Vorteil kann darin bestehen, daß in einem durch Radiofrequenz angeregten Plasma die negativ geladenen Elementarteilchen, die Elektronen, einen größeren Bewegungsbereich aufweisen mit der Folge, daß aufgrund der dadurch bedingten Ausbildung der Randschichten des Plasmas Bedingungen für die Bildung der Deckschicht durch Polymerisation vorhanden sind, die bei Anwendung von Mikrowellen nicht erreicht werden können.

Es ist aber auch möglich, das Plasma durch Anwendung von Mikrowellen zu erzeugen. Ferner besteht die Möglichkeit, das Plasma innerhalb des Hohlkörpers durch gleichzeitige Anwendung sowohl von Radiofrequenz als auch von Mikrowellen zu erzeugen. Dadurch würde neben den bereits erwähnten Vorteilen bei der Anwendung der Radiofrequenz zur Erzeugung des Plasmas auch der den Mikrowellen eigene Vorteil nutzbar gemacht werden, der insbesondere in einer höheren Abscheiderate aus dem Plasma und damit in einer kürzeren Prozeßzeit, d.h., einer höheren Produktivität des Verfahrens, besteht.

Um die Durchlässigkeit der Deckschicht für Alkohol, insbesondere Methanol, zu minimieren, sollten die die Deckschicht bildenden Substanzen möglichst unpolar sein. Dazu werden im wesentlichen unpolare Ausgangssubstanzen verwendet, da letztere diese Eigenschaft auch bei ihrer Polymerisation nicht verlieren und somit eine Deckschicht aus zumindest überwiegend unpolaren Substanzen bilden. Bei den Ausgangssubstanzen kann es sich erfindungsgemäß z.B. um gas- oder dampfförmige Kohlenstoff- und Siliziumverbindungen handeln, die die Bildung hochvernetzter Polymerschichten erwarten lassen und zu einer permeationsdichten Barriereschicht führen. Geeignete unpolare Ausgangssubstanzen sind z.B. Kohlenwasserstoffe oder Siloxane.

In der Zeichnung sind einige Ausführungsbeispiele im Schema dargestellt. Es zeigen:
- Fig. 1: eine erste Ausführungsform einer Einrichtung zum Aufbringen einer polymeren Deckschicht auf der inneren Oberfläche eines Hohlkörpers aus Kunststoff unter Verwendung von Radiofrequenz zur Erzeugung des Plasmas
- Fig. 2: eine der Fig. 1 entsprechende Darstellung einer zweiten Ausführungsform,
- Fig. 3: die Darstellung einer dritten Ausführungsform,
- Fig. 4: eine Einrichtung zum gleichzeitigen Behandeln mehrerer Hohlkörper,
- Fig. 5: eine Einzelheit in größerem Maßstab.
- Fig. 6: eine der Fig. 1 entsprechende Darstellung einer dritten Ausführungsform,
- Fig. 7: eine vierte Ausführungsform, bei welcher das Plasma unter Verwendung von Mikrowellen erzeugt wird.

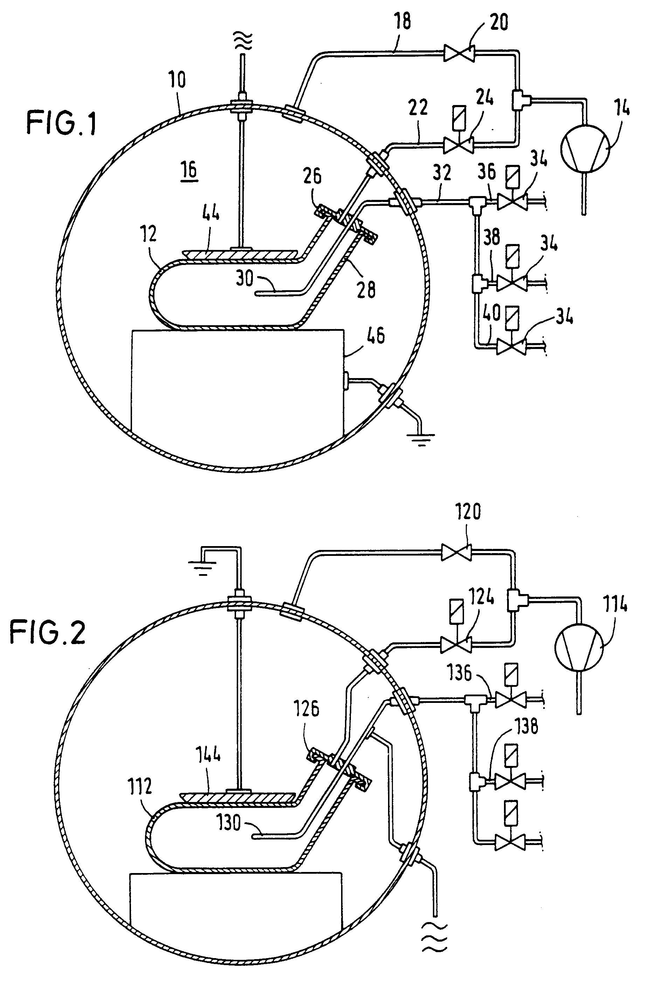

Beim Ausführungsbeispiel gemäß Fig. 1 ist eine Vakuumkammer 10 vorhanden, innerhalb derer Kraftstoff-Tanks aus thermoplastischem Kunststoff mit einer Innenbeschichtung in Form einer polymeren Deckschicht zu versehen sind. In Abhängigkeit von der Größe des jeweils zu behandelnden Tanks 12 kann die Vakuumkammer ein Volumen von beispielsweise 300 l aufweisen. Sie ist vorzugsweise an einer ihrer Stirnseiten mit einer verschließbaren Öffnung versehen, durch die der jeweils mit der Beschichtung zu versehende Tank 12 in die Vakuumkammer 10 eingebracht werden kann. Letztere wird anschließend verschlossen und danach gemeinsam mit dem Tank 12 durch eine Vakuumpump-Einrichtung 14 evakuiert. Die Verbindung zwischen Vakuumpump-Einrichtung 14 und dem Innenraum 16 der Vakuumkammer 10 wird über eine Leitung 18 hergestellt, die mit einem Ventil 20 versehen ist.

Das Innere des Tanks 12 ist über eine Leitung 22 mit der Vakuumpump-Einrichtung 14 verbunden. In der Leitung 22 ist ein Ventil 24 angeordnet. Die Öffnung des Tankes 12, durch welche die Evakuierung erfolgt, ist durch einen lösbaren Schnellverschluß 26 in Form einer Kappe oder dgl. verschlossen, die mittels beispielsweise eines Bajonettverschlusses am Stutzen 28 des Tanks angebracht werden kann. Die Leitung 22 für die Evakuierung des Tanks 12 ist mit einer Öffnung in diesem Deckel dicht verbunden. Eventuell weitere noch am Tank 12 vorhandene Öffnungen, die beispielsweise herstellungsbedingt sein können, sind zuvor verschlossen worden. Es kann aber auch zweckmäßig sein, solche weiteren Öffnungen, die bei Verwendung des Tanks beispielsweise in einem Kfz. erforderlich sind, nach der Beschichtung mittels Plasmapolymerisation anzubringen.

Innerhalb des Tankes 12 ist in der üblichen Weise eine Sonde 30 angeordnet, die der Zuführung der Ausgangssubstanz(en) zur Bildung der polymeren Deckschicht dient. Die Sonde 30 ist ebenfalls mit der Kappe oder dgl. des Schnellverschlusses 26 dicht verbunden, die dazu mit einer weiteren Öffnung versehen ist, an welcher eine Zuleitung 32 angeschlossen ist. Die Zuleitung 32 stellt eine Sammelleitung dar, in welche unter Zwischenschaltung jeweils eines Absperrorgans 34 Leitungen 36, 38, 40 münden, die jeweils mit nicht dargestellten Vorratsbehältern oder dgl. für mindestens eine Ausgangssubstanz und ggf. weitere Substanzen(en) verbunden sind. So kann beispielsweise über die Leitung 36 die Ausgangssubstanz für die überwiegend kettenbildende Komponente zugeführt werden. Die Leitung 38 kann der Zuführung der Ausgangssubstanz(en) für die überwiegend die Verzweigungs- bzw. Vernetzungsstellen ausbildende Komponente dienen. Über die Leitung 40 kann die Komponente zugeführt werden, die die Staubbildung innerhalb des Tankes 12 hemmt.

Die Evakuierung des Innenraums 16 der Vakuumkammer 10 und des Tanks 12 erfolgt zunächst gemeinsam. Bei Erreichen eines Druckes von ca. 1000 Pa wird das Ventil 20 geschlossen, so daß der Druck innerhalb des Raumes 16 nicht unter 1000 Pa fällt. Das Innere des Tanks 12 wird weiter bis zu einem Druck von ca. 1 Pa evakuiert. Anschließend wird über Leitung 32 und Sonde ein Gasgemisch aus z. B. 50% Ethylen, 30% Acetylen und 20% Methan in den Tank 12 geben. Mit Hilfe des Drosselventils 24 wird bei laufender Pumpe ein Druck von 6 Pa eingestellt. Die Durchflußraten für die vorgenannten Gase betragen jeweils 25 bzw. 15 bzw. 10 cm³/min, d. h., daß der größte Anteil im Gasgemisch auf die überwiegend kettenbildende und der geringste Anteil auf die Staub hemmende Komponente entfällt.

Danach wird eine innerhalb der Vakuumkammer in einem geringen Abstand vom Tank 12 oberhalb desselben angeordnete Flächenelektrode 44 an eine Hochfrequenzspannung von 13,56 MHz mit einer Leistung von 100 W angelegt. Dies führt zur Zündung eines Plasmas innerhalb des Tankes 12, welches während etwa 30 min aufrechterhalten wird. Außerhalb des Tanks 12 im Innenraum 16 entsteht kein Plasma, da dazu der Druck im Innenraum 16 zu hoch ist. Außerdem wirkt die Positionierung der Elektrode 44 der Zündung eines Plasmas im Innenraum 16 entgegen. Der Tank 12 liegt innerhalb der Vakuumkamer 10 auf einer geerdeten Auflage 46, die die zweite Elektrode darstellt.

Während des Beschichtungsvorganges wird das Plasma mit einem optischen Sensor, der die Helligkeit des Plasmas integral im Wellenbereich von 300 bis 900 nm detektiert, beobachtet. Diese Maßnahme dient insbesondere der Konstanthaltung des Plasmas, um so die Bildung einer Deckschicht mit reprodzierbaren Eigenschaften zu erhalten.

Anschließend wird die Hochfrequenzspannung abgeschaltet, der Gaszufluß unterbrochen und erneut auf 1 Pa evakuiert. Nach Beendigung des Evakuierens werden Kammer 10 und Tank 12 belüftet. Schnellverschluß 26 und Sonde 30 werden entfernt. Auf der gesamten Innenfläche des Tanks 12 hat sich eine dichte Schicht mit einer Dicke von 0,1 bis 0,4 µm gebildet, die die Durchlässigkeit der Wandung des Tankes 12 für einen Testkraftstoff, der aus 85% n-Pentan und 15% Methanol besteht nach ECE 34 auf 0,4 g/d vermindert. Bei unbehandelten Tanks beträgt die Durchlässigkeit etwa 20 g/d.

Das Ausführungsbeispiel gemäß Fig. 2 stimmt in wesentlichen Teilen mit dem gemäß Fig. 1 überein, so daß gleiche Teile mit gleichen, jedoch um 100 höheren Bezugszeichen versehen sind. Der wesentliche Unterschied besteht darin, daß bei der Einrichtung gemäß Fig. 2 die innerhalb des Tanks 112 angeordnete Sonde 130 als Elektrode dient, an welcher eine Wechselspannung von 125 KHz und mit einer Leistung von 150 W angelegt wird. Die auch hier verwendete Flächenelektrode 144 ist geerdet. Die Konstanz des sich innerhalb des Tankes 112 ausbildenden Plasmas wird mit einer speziellen Ionenstrom- oder einer Langmuir-Sonde, die an der Sonde 130 angebracht ist, überwacht. Das Reaktionsgas besteht in diesem Fall aus 50% Ethylen und 50% Acethylen. Es wurde festgestellt, daß bei diesen Betriebsbedingungen auf die Zuführung einer staubhemmenden Komponente verzichtet werden kann. D. h., daß die Ausgangssubstanzen in diesem Fall lediglich über die Leitungen 136, 138 zugeführt werden.

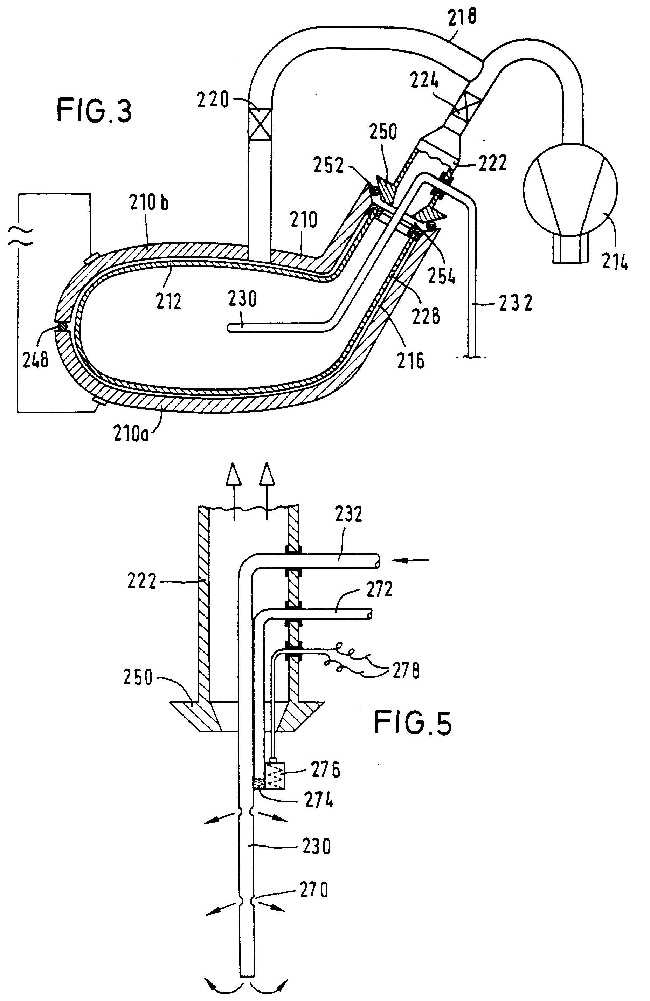

In der Ausführungsform gemäß Fig. 3 sind ebenfalls jene Teile, die denen des Ausführungsbeispiels gemäß Fig. 1 entsprechen, mit gleichen, jedoch um 200 höheren Bezugszeichen versehen. Der wesentliche Vorteil des Ausführungsbeispiels gemäß Fig. 3 besteht in der Verwendung einer Vakuumkammer 210, deren Wandung weitgehend an die Gestalt des in der Vakuumkammer zu behandelnden Kunststofftankes 212 angepaßt ist. D.h., daß die innere Begrenzung der Vakuumkammer 210 im wesentlichen der äußeren Begrenzung des Tankes 212 entspricht. Ein wesentlicher Vorteil dieser Anordnung besteht in dem geringen Volumen des vom Tank 212 nicht ausgefüllten Innenraums 216 der Vakuumkammer, wodurch die für die Evakuierung dieses Innenraumes 216 erforderliche Zeit erheblich reduziert und die Übertragung der Radiofrequenzspannung in das Innere des Tankes 212 optimiert wird. Dies führt zu einer merklichen Verkürzung der für das Aufbringen einer Beschichtung mit bestimmten Qualitäten erforderlichen Behandlungsdauer im Vergleich zu den Ausführungsbeispielen gemäß Fig. 1 und 2. Insgesamt wird auch der Investitionsaufwand für die Einrichtung reduziert.

Zur Erleichterung der Handhabung der Einrichtung ist die Vakuumkammer 210 etwa hälftig unterteilt derart, daß eine untere Hälfte 210a und eine obere Hälfte 210b entstehen, von denen die obere Hälfte 210b als Deckel ausgebildet ist, der von der unteren, stationären Hälfte 210a abgenommen werden kann. Die beiden Teile 210a, 210b sind durch eine Dichtung 248 aus gummielastischem Material gegeneinander elektrisch isoliert. Diese Dichtung bewirkt in geschlossenem Zustand der Kammer 210 zugleich deren Abdichtung gegenüber der Außenatmosphäre.

Von der Vakuumpumpeinrichtung 214 geht eine Leitung 218 für die Evakuierung der Vakuumkammer 210 ab. Die andere Saugleitung 222 ist so ausgebildet und angeordnet, daß sie mit einem an ihrem Endbereich angebrachten Flansch 250, der konisch ausgebildet ist, unter Zwischenschaltung eines Dichtringes 252, an dem eine Öffnung 254 der Vakuumkammer 210 begrenzenden Wandteil der Kammer anliegt, so daß die Öffnung 254 durch den Flansch 250 der Saugleitung 222 verschlossen wird. Die Öffnung des Tanks 212 ist auch hier durch die Kappe eines Schnellverschlusses 226 verschlossen, der mit einer zusätzlichen Öffnung für das Vakuum versehen ist. Die Anordnung kann aber auch so getroffen sein, daß die Saugleitung 222 mit ihrem freien Ende in den Stutzen 228 des Tanks 212 eingreift und diesen dabei nach außen abdichtet. Dazu könnte die Saugleitung mit einem Abschnitt kleineren Durchmesser versehen sein, der über den Flansch 250 in Richtung auf den Tank vorsteht.

Auch hier ist eine innerhalb des Tankes 212 angeordnete Sonde 230 vorgesehen, durch die die für die Bildung der polymeren Deckschicht erforderlichen Substanzen und ggf. auch die die Bildung von Staub hemmende Komponente eingeführt werden. Der Sonde können darüberhinaus auch die anderen Einrichtungen für Überwachung des Plasmas usw. zugeordnet sein. Saugleitung 222 und Sonde 230 sowie weitere zugeordnete Teile können so angeordnet sein, daß beim Einlegen des Tanks 212 in die Vakuumkammer Saugleitung 222 und Sonde 230 mit zugeordneten Teilen zwangsläufig in die richtige Lage zum Tank 212 gebracht werden, bei welcher eine gute Verteilung der Substanzen zur Bildung der Deckschicht im Hohlkörper erreicht wird. Beim Schließen der Vakuumkammer 210 durch entsprechende Positionierung der oberen Hälfte 210b erfolgt dann die endgültige Abdichtung der Vakuumkammer gegen die Außenatmosphäre und die Abdichtung des in der Kammer 210 befindlichen Tanks 212 gegenüber dem Innenraum 216 der Vakuumkammer.

Zur Erzeugung des Plasmas kann eine Radiofrequenz im Bereich von 30 bis ca. 500 kHz bzw. 6,78, 13,56, 27,12 oder 40,68 MHz angelegt werden. Fig. 3 zeigt eine Ausführungsform, bei welcher die Radiofrequenz potentialfrei kapazitiv an beiden Teilen 210a, 210b angelegt ist. Es besteht aber auch die Möglichkeit, analog der Ausführungsform gemäß Fig. 2 die Sonde 230 als Elektrode zu verwenden, wobei beide Hälften 210a, 210b geerdet sind. Eine andere Möglichkeit besteht darin, die Radiofrequenz an eine der beiden Hälften 210a, 210b anzulegen und die jeweils andere Hälfte zu erden.

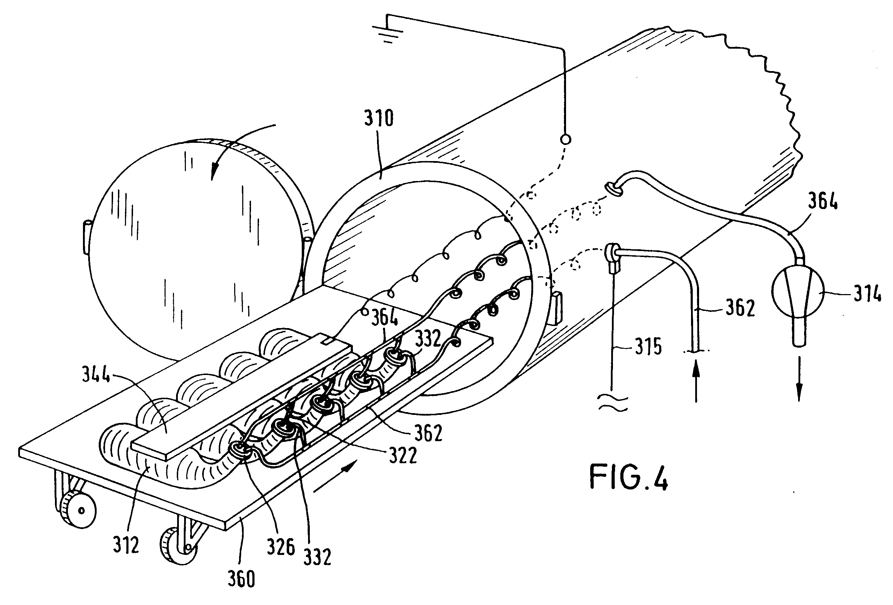

Das Ausführungsbeispiel gemäß Fig. 4, in welcher dem Ausführungsbeispiel gemäß Fig. 1 entsprechende Teile mit gleichen, jedoch um 300 höheren Bezugszeichen versehen sind, ist mit einer Vakuumkammer 310 versehen, die so groß ist, daß sie die gleichzeitige Behandlung mehrerer, z.B. zehn auf einem Beschickungswagen 360 angeordneter Tanks 312 ermöglicht. Dabei ist in Übereinstimmung mit dem Ausführungsbeispiel gemäß Fig. 2 eine oberhalb der Gesamtheit aller Tanks 312 angeordnete Flächenelektrode 344 vorgesehen, die entsprechend dimensioniert und geerdet ist. In jeden der Tanks 312 wird eine Sonde eingeführt. Die einzelnen Tanks 312 sind in der bereits im Zusammenhang mit den Figuren 1 und 2 beschriebenen Weise mit einem Schnellverschluß 326 versehen, der die Sonde trägt und gleichzeitig auch mit einem Durchlaß für die Ausgangssubstanz(en) für die polymere Deckschicht versehen ist. Die Zuleitungen 332 sämtlicher Tanks 312 sind an eine gemeinsame Versorungsleitung 362 angeschlossen, die wiederum in geeigneter Weise mit Vorratsbehältern für die einzelnen Komponenten verbunden ist, wie dies im Zusammenhang mit Figur 1 beschrieben wird. Ferner sind die Saugleitungen 322 sämtlicher Tanks 312 an eine gemeinsame zentrale Saugleitung 364 angeschlossen. Über die elektrische Leitung 315 wird die Wechselspannung an die Sonden 330 angelegt. Diese Wechselspannung kann z.B. 13.56 MHz betragen.

Die zu behandelnden Tanks 312 können außerhalb der Vakuumkammer 310 auf den Beschickungswagen 360 gelegt werden, der dann in die Vakuumkammer 310 eingefahren wird. Über eine Schnellkupplung ggf. auch über eine gemeinsame Schnellkupplung für alle Leitungen, können dann die Verbindungen für die Gaszufuhrleitungen und die Leitung zum Evakuieren der einzelnen Tanks 312 und für den Anschluß der Wechselspannung hergestellt werden.

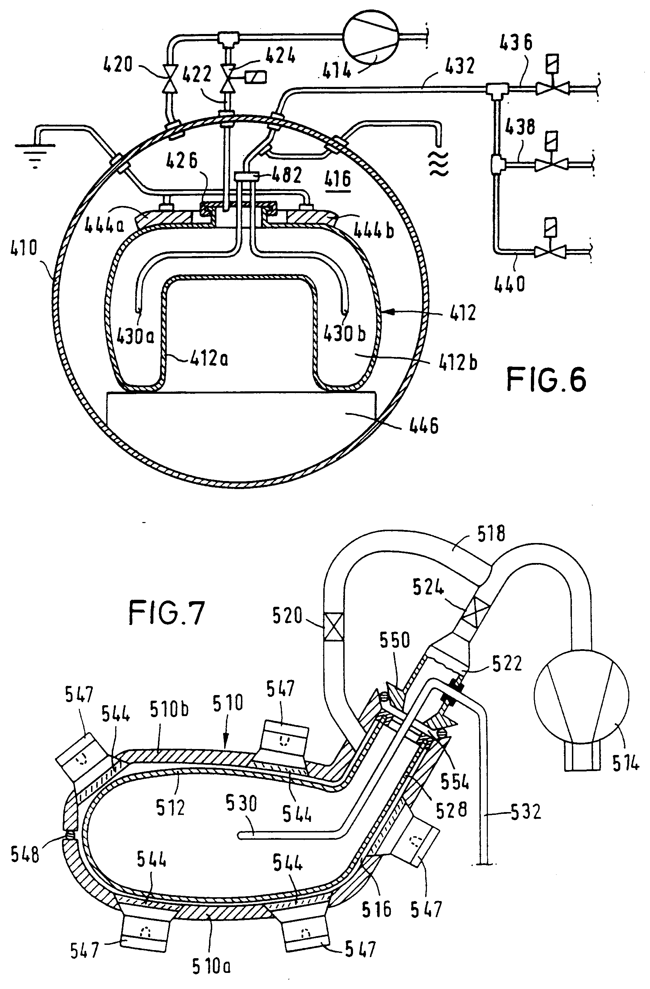

Fig. 5 zeigt einige Einzelheiten einer möglichen Ausgestaltung der Absaugleitung für den Tank und die in den Tank einzuführende Sonde mit weiteren Teilen und Einrichtungen. Im folgenden werden dazu die Bezugszeichen des Ausführungsbeispiels gemäß Fig. 3 verwendet, wenngleich die in Fig. 5 dargestellte Anordnung auch mit geringfügigen Änderungen bei den anderen Ausführungsbeispielen verwendet werden kann. Die Zuleitung 232 wird durch die Wandung des Saugrohres 222 in dieses eingeführt. Es erstreckt sich nach einer rechtwinkligen Abbiegung im wesentlichen koaxial durch das Saugrohr 222 hindurch in Richtung auf den Tank, in den hinein es sich als Sonde 230 fortsetzt. Die Sonde ist mit Bohrungen 270 für den Austritt der gas- bzw. dampfförmigen Ausgangssubstanz(en) versehen. Ferner ist eine Lichtleitfaser 272 vorgesehen, die im wesentlichen parallel zur Leitung 232 verläuft und etwa am Übergang von dieser zur Sonde 230 endet, so daß in der Betriebslage der Teile eine Beobachtung des Plasmas im Tank möglich ist. An diesem Ende ist die Lichtleitfaser 272 durch ein Fenster 274 verschlossen, durch welches die Beobachtung des im Tank 212 gezündeten Plasmas erfolgt. Dem Fenster 274 ist eine Widerstandsheizung 276 zugeordnet, durch die das Fenster 274 auf eine Temperatur erwärmt wird, die das Absetzen einer Deckschicht auf diesem Fenster verhindert, so daß es durchsichtig bleibt. Die elektrischen Zuleitungen für die Heizung 276 sind mit 278 bezeichnet.

Im Falle der Ausführungsform gemäß den Figuren 1 und 2 würde das Saugrohr am Schnellverschluß 26 bzw. 126 enden können, während die Zuleitung 232 für die Ausgangssubstanz durch eine Durchbrechung in der Kappe oder dergleichen des Schnellverschlusses hindurchgeführt wäre. Letzteres gilt auch für die Lichtleitfaser und die elektrischen Zuleitungen für die dem Fenster zugeordnete Widerstandsheizung.

Abweichend von den in den Figuren 1-4 dargestellten Ausführungsbeispielen besteht auch die Möglichkeit, mehr als eine Sonde innerhalb desselben Hohlkörpers vorzusehen. Dies wird insbesondere dann zweckmäßig sein, wenn der Hohlkörper eine Gestalt aufweist, die es schwierig macht, bei Verwendung lediglich einer Sonde eine gleichmäßige Verteilung der Substanzen für die Bildung der Deckschicht zu erreichen. Eine derartige Ausführungsform ist in Fig. 6 dargestellt, wobei der grundsätzliche Aufbau dieser Ausführungsform mit den der Fig. 2 übereinstimmt, so daß gleiche Teile mit gleichen, jedoch um 300 höheren Bezugszeichen versehen sind. Mit Fig. 1 übereinstimmende Teile sind demzufolge mit um 400 größeren Bezugszeichen versehen.

Der wesentliche Unterschied gemäß der Ausführungsform gemäß Fig. 2 besteht darin, daß aufgrund der im Querschnitt etwa U-förmigen Gestalt des Tankes 412 (Satteltank) zwei Sonden 430a und 430b verwendet werden, die beide zugleich als Elektrode dienen, an welcher eine Wechselspannung von z.B. 125kHz und einer Leistung von z.B. 150 Watt angelegt wird. Die auch verwendete außerhalb des Tankes 412 angeordnete Flächenelektrode ist in zwei Bereiche 444a und 444b derart unterteilt, daß jedem dieser beiden Bereiche eine der beiden Sonden 430a und 430b zuordnet ist. Da der Tank 412 einigermaßen symmetrisch ausgebildet ist, sind auch die beiden Sonden entsprechend angeordnet. Es ist aber durchaus möglich, bei einem unregelmäßig ausgebildeten Tank die Sonden asymmetrisch, entsprechend der jeweiligen Gestalt des Tankes, anzuordnen. Es ist auch eine Ausführungsform denkbar, bei welcher mehr als zwei Sonden vorhanden sind. Entscheidend ist in allen Fällen, die Voraussetzungen dafür zu schaffen, daß über den gesamten Innenraum des Tanks ein möglichst uniformes Plasma entsteht und daß eine möglichst gleichmäßige Verteilung der Substanzen, aus denen die Deckschicht hergestellt wird, gewährleistet ist. Abweichend von der Darstellung gemäß Fig. 6 besteht auch die Möglichkeit, bei Verwendung von mehr als einer Sonde diese Sonden lediglich für die Zuführung der Substanz(en) für die Bildung der Deckschicht zu verwenden und wenigstens eine zweite Elektrode außerhalb des Tanks vorzusehen, wie dies beispielsweise bei der Ausführungsform gemäß Fig.1 der Fall ist.

Bei der Ausführungsform gemäß Fig. 6 sind die beiden Sonden 430a und 430b über ein Verbindungsstück 482 an die Zuleitung 432 angeschlossen. Dabei werden beide Sonden 430a und 430b durch dieselbe Öffnung des Tanks 412, die durch die Kappe 426 verschlossen ist, in den Tank eingeführt. Selbstverständlich ist es auch möglich, die beiden Sonden durch unterschiedliche Öffnungen am Tank in das Innere desselben einzuführen. Dies wird immer dann in Betracht zu ziehen sein, wenn am Tank ohnehin mehr als eine Öffnung vorhanden und der Tank so unregelmäßig ausgebildet ist, daß das Hineinführen der Sonden durch unterschiedliche Öffnungen, die demzufolge auch an unterschiedlichen Stellen in der Tankwandung angebracht sind, eine optimale Anordung der Sonden innerhalb des Tankes erleichtert. Im allgemeinen wird es darauf ankommen, die Sonden jeweils in Bereichen des Innenraumes, die nur durch Zwischenbereiche mit geringen Querschnittsabmessungen miteinander verbunden sind, anzuordnen. Im übrigen besteht auch die Möglichkeit, eine der Sonden lediglich als Elektrode auszubilden. Wie dabei im einzelnen Verfahren wird, hängt von den Umständen des Einzelfalles ab. Im allgemeinen wird eine Zuführung der Ausgangssubstanz(en) durch mehrere Sonden ebenfalls zur Gleichmäßigkeit des Plasmas und damit zur Uniformität der herzustellenden Deckschicht beitragen. Selbstverständlich ist auch bei Vorhandensein von mehr als einer Öffnung am Tank dafür zu sorgen, daß alle Öffnungen verschlossen sind, um die für die Bildung des Plasmas erforderlichen Bedingungen innerhalb des Hohlkörpers schaffen zu können.

Das in Fig. 7 dargestellte Ausführungsbeispiel stimmt in wesentlichen Teilen mit dem gemäß Fig. 3 überein, so daß der Fig. 3 entsprechende Teile auch mit gleichen, jedoch um 300 höheren Bezugszeichen versehen sind. Der wesentliche Unterschied besteht darin, daß beim Ausführungsbeispiel gemäß Fig. 7 das Plasma durch Mikrowellen erzeugt wird, wobei auch hier die Wandung der Vakuumkammer 510 weitgehend an die Gestalt des zu behandelnden Kunststofftanks 512 angepaßt ist. Dadurch wird nicht nur die für die Evakuierung des Innenraums 516 erforderliche Zeit erheblich reduziert. Vielmehr bewirkt diese Ausgestaltung auch eine Optimierung des Einkoppelns der Mikrowellen in das Innere des Tankes 512. Dies führt zu einer merklichen Verkürzung der für das Aufbringen einer Beschichtung mit bestimmter Qualität erforderlichen Behandlungsdauer im Vergleich beispielsweise mit einer Vakuumkammer mit einer Gestaltung gemäß Fig. 1.

Die Wandung der Vakuumkammer 510 ist mit Mikrowellenfenstern 544 aus Quarzglas versehen, über welche die Mikrowellen, die jeweils von einem Mikrowellengenerator 547, der außerhalb der Vakuumkammer 510 angeordnet ist, in letzterer eingekoppelt werden. Abweichend von der in Fig. 7 der Zeichnung dargestellten Ausgestaltung, bei welcher jedem Mikrowellenfenster 544 ein eigener Mikrowellengenerator 547 zugeordnet ist, besteht auch die Möglichkeit, für die Vakuumkammer 510 lediglich einen Mikrowellengenerator zu verwenden, wobei dann über einen geeigneten Verteiler und Leitungen die Mikrowellen zu den einzelnen Mikrowellenfenstern geführt werden. Auch hier können der innerhalb des Tankes 512 angeordneten Sonde 530 für die Zuführung der für die Bildung der polymeren Deckschicht erforderlichen Substanzen und ggf. auch der die Bildung von Staub hemmenden Komponente Einrichtungen für die Überwachung des Plasmas usw. zugeordnet sein.

## Patentansprüche

1. Einrichtung zum Herstellen wenigstens einer polymeren Deckschicht auf wenigstens einem Teilbereich der inneren Oberfläche eines zumindest teilweise aus Kunststoff bestehenden Hohlkörpers unter Anwendung der Niederdruckplasmapolymerisation mit einer den Hohlkörper aufnehmenden Vakuumkammer und Mitteln zum Einführen wenigstens der Ausgangssubstanz(en) für die Bildung der polymeren Deckschicht und Mitteln zum Einkoppeln von hochfrequenter elektromagnetischer Energie zur Erzeugung des Plasmas, dadurch gekennzeichnet, daß zumindest die innere Begrenzung der Vakuumkammer (210; 510) der äußeren Gestalt des Hohlkörpers (212; 512) angepaßt ist.

2. Einrichtung nach Anspruch 1, dadurch gekennzeichnet, daß sie mit mindestens zwei Elektroden (17, 44; 130, 144; 210a, 210b; 330, 344; 430a, 430b; 444a, 444b) versehen ist, zwischen denen eine hochfrequente Spannung zur Erzeugung des Plasmas anliegt, und wenigstens eine der Elektroden innerhalb der Vakuumkammer außerhalb des Hohlkörpers (12; 112; 212; 312; 412) in unmittelbarer Nähe desselben angeordnet ist.

3. Einrichtung nach Anspruch 1, dadurch gekennzeichnet, daß die Wandung der Vakuumkammer (510) mit wenigstens einem Fenster (544) zum Einkoppeln der Mikrowellen in die Vakuumkammer versehen ist.

4. Einrichtung nach Anspruch 1, dadurch gekennzeichnet, daß die Einrichtung zum Einkoppeln der Mikrowellen mit wenigstens einer Mikrowellen-Stabantenne versehen ist.

5. Einrichtung nach Anspruch 1, dadurch gekennzeichnet, daß die Einrichtung zum Einkoppeln der Mikrowellen mit wenigstens einer Schlitzantenne versehen ist.

6. Einrichtung nach einem der Ansprüche 3 - 5, dadurch gekennzeichnet, daß die Vakuumkammer mit wenigstens einer Einrichtung zum Streuen der Mikrowellen versehen ist.

7. Einrichtung nach Anspruch 2, dadurch gekennzeichnet, daß die wenigstens zwei Elektroden außerhalb des Hohlkörpers angeordnet sind.

8. Einrichtung nach Anspruch 2, dadurch gekennzeichnet, daß wenigstens eine Elektrode (130; 330) innerhalb des Hohlkörpers (112; 312) angeordnet ist.

9. Einrichtung nach Anspruch 7, dadurch gekennzeichnet, daß wenigstens eine Elektrode innerhalb der Vakuumkammer (10) eine Auflage (17) für den Hohlkörper (12) bildet.

10. Einrichtung nach Anspruch 2, dadurch gekennzeichnet, daß die wenigstens eine in unmittelbarer Nähe des Hohlkörpers (212), jedoch außerhalb desselben angeordnete Elektrode (210a, 210b) an ihrer dem Hohlkörper zugekehrten Seite eine Topographie aufweist, die der Topographie zumindest eines Teilbereiches des Hohlkörpers (212) angepaßt ist.

11. Einrichtung nach Anspruch 2 und 3, dadurch gekennzeichnet, daß sie mit Mitteln zum gleichzeitigen Erzeugen eines Radiofrequenzplasmas und eines Mikrowellenplasmas in demselben Hohlkörper versehen ist.

12. Einrichtung nach Anspruch 2, dadurch gekennzeichnet, daß die Wandung der Vakuumkammer (210) in zwei gegeneinander elektrisch isolierte Teile (210a, 210b) unterteilt ist, von denen jedes eine der Elektroden bildet.

13. Einrichtung nach Anspruch 1, dadurch gekennzeichnet, daß die Mittel (30; 130; 230; 430a, 30b; 530) zum Einführen wenigstens der Ausgangssubstanz(en) für die Bildung der polymeren Deckschicht als wenigstens eine innerhalb des Hohlkörpers angeordnete Sonde ausgebildet sind.

14. Einrichtung nach Anspruch 13, dadurch gekennzeichnet, daß wenigstens eine Sonde (130; 530a, 530b) als Elektrode ausgebildet ist.

15. Einrichtung nach Anspruch 13, dadurch gekennzeichnet, daß die wenigstens eine Öffnung des Hohlkörpers (12; 112; 412) durch einen Schnellverschluß verschließbar ist, durch den die wenigstens eine Sonde (30; 130; 430a, 430b) sich in den Hohlkörper erstreckt.

16. Einrichtung nach Anspruch 13, dadurch gekennzeichnet, daß wenigstens zwei Sonden (430a, 430b) innerhalb des Hohlkörpers (412) angeordnet sind, derart, daß eine möglichst gleichmäßige Verteilung de Ausgangssubstanz(en) zur Bildung der polymeren Deckschicht innerhalb des Hohlkörpers erreicht wird.

17. Einrichtung nach Anspruch 16, dadurch gekennzeichnet, daß beide Sonden (430a, 430b)auch zugleich auch als innerhalb des Hohlkörpers (412) befindliche Elektrode dienen.

18. Einrichtung nach Anspruch 1, dadurch gekennzeichnet, daß der gegenüber dem Innenraum (16; 116; 216; 316; 416; 516) der Vakuumkammer (10; 110; 210; 310; 410; 510) verschlossene Hohlkörper (12; 112; 212; 312; 412; 512) und der Bereich der Vakuumkammer außerhalb des Hohlkörpers getrennt voneinander evakuierbar sind.

19. Einrichtung nach Anspruch 1, dadurch gekennzeichnet, daß innerhalb des Hohlkörpers (212) ein Sensor (272) zur Beobachtung des Betriebszustandes im Bereich des Plasmas angeordnet ist.

20. Einrichtung nach Anspruch 12, dadurch gekennzeichnet, daß der Sensor (272) der Sonde (230) zugeordnet ist.

21. Einrichtung nach Anspruch 12, dadurch gekennzeichnet, daß der optische Sensor als Lichtleitfaser (272) ausgebildet ist, die an ihrem im Inneren des Hohlkörpers (212) befindlichen Ende durch ein Fenster (274) verschlossen ist.

22. Einrichtung nach Anspruch 14, dadurch gekennzeichnet, daß dem Fenster (274) eine Heizeinrichtung (276) zugeordnet ist, die das Ablagern einer polymeren Deckschicht auf dem Fenster verhindert.

23. Einrichtung nach Anspruch 1, dadurch gekennzeichnet, daß sie zur Beobachtung des Plasmas mit einer Ionenstromsonde versehen ist.

24. Einrichtung nach Anspruch 1, dadurch gekennzeichnet, daß sie zur Beobachtung des Plasmas mit einer Langmiur-Sonde versehen ist.

25. Einrichtung nach Anspruch 1, dadurch gekennzeichnet, daß bei gleichzeitiger Behandlung mehrerer Hohlkörper (312) jedem der Hohlkörper eine innerhalb desselben befindliche Sonde (330) zugeordnet ist und Gaseinlaßrohre und Pumprohre der einzelnen Sonden jeweils an eine zentrale Gaszuführungs-Leitung und eine zentrale Evakuierungsleitung angeschlossen sind.

26. Einrichtung nach Anspruch 18, dadurch gekennzeichnet, daß die Hohlkörper (312) auf einem ein die Vakuumkammer (310) einführbaren Wagen angeordnet sind, an welchem die Sonden bzw. das gemeinsame Gaszuführungsrohr und/oder die gemeinsame Evakuierungsleitung angebracht sind.
